# EUROPEAN PATENT SPECIFICATION

(11) **EP 3 300 120 B1**
(45) Date of publication and mention of the grant of the patent: **18.03.2020**
(21) Application number: 16799960.6
(22) Date of filing: 20.05.2016
(51) Int. Cl.: H01L 29/82, H01L 43/08, H03K 3/59, H01F 10/32

(54) **PULSE GENERATION DEVICE**
IMPULSERZEUGUNGSVORRICHTUNG
DISPOSITIF DE GÉNÉRATION D'IMPULSIONS

(30) Priority: 22.05.2015 JP 2015104335
(43) Date of publication of application: 28.03.2018
(73) Proprietor: Japan Science and Technology Agency, Saitama 332-0012 (JP); The University of York, Heslington York YO10 5DD (GB)
(72) Inventor: HIROHATA, Atsufumi, Heslington, York YO10 5DD (GB)
(74) Representative: Plasseraud IP
(86) International application number: PCT/JP2016/065071
(87) International publication number: WO 2016/190255

(56) References cited:
- WO-A1-2011/118374
- WO-A1-2014/024697
- WO-A1-2015/064663
- WO-A1-2015/064663
- JP-A- 2005 019 561
- JP-A- 2012 049 403
- JP-B2- 5 645 181
- US-A1- 2013 069 730

## Description

### Technical Field

The present disclosure relates to a pulse generation device.

### Background Art

Patent Literature 1 describes a pulse generation device that converts a waveform of an input signal from a signal source into a rectangular wave pulse. Further, a rectangular wave pulse with a short pulse width is used for communication devices, radar devices, and the like. For example, Patent Literature 2 describes a communication method using an impulsive pulse train with a very short pulse width. Further, Patent Literature 3 describes a radar device including a high-frequency device using a rectangular wave pulse with a short pulse width.

### Citation List

### Patent Literature

Patent Literature 1: Japanese Unexamined Patent Publication No. 2007-013441
Patent Literature 2: Japanese Unexamined Patent Publication No. 2013-192006
Patent Literature 3: Japanese Unexamined Patent Publication No. 2013-083541
Patent Literature 4: U.S. patent application publication No. US2013/0069730 A1 (Spin-torque Oscillator)

### Summary of Invention

### Technical Problem

To shorten the pulse width in the conventional pulse generation device, use of an input signal with a higher frequency is necessary. However, the higher the frequency, the shorter the width of a rising component or a falling component of the waveform, and thus accurate detection of the rising or falling of the waveform is difficult. Therefore, in the conventional pulse generation device, there is a limit to the short pulse width that can be generated.

In the present technical field, a pulse generation device capable of generating a pulse with a short pulse width is desired.

### Solution to Problem

A pulse generation device according to an aspect of the present invention includes a substrate, a spin injector provided over the substrate and made of a ferromagnetic body, a spin rotor provided over the substrate, made of a ferromagnetic body, and having magnetic anisotropy in which a direction of a first axis becomes an easy axis of magnetization, a channel portion made of a nonmagnetic body, and joined with the spin injector and the spin rotor directly or via an insulating layer, and characterized by a generating portion configured to detect a physical quantity or a physical property value that varies according to a direction of a magnetic moment of the spin rotor when the magnetic moment of the spin rotor is reversed from one side of the first axis to the other side of the first axis, and configured to generate a pulse based on the physical quantity or property value that corresponds to a state in which the magnetic moment of the spin rotor faces a direction along a second axis orthogonal to the first axis.

In this pulse generation device, a spin current toward the spin rotor is generated in the channel portion by using a local technique or a non-local technique. For example, when a current or a voltage is applied to the spin injector and the channel portion, a spin current toward the spin rotor is generated in the channel portion. The spin current flowing in the channel portion acts on the magnetic moment of the spin rotor as spin-transfer torque. That is, when a precessing magnetic moment receives a spin angular momentum from the spin current, a rotational force is applied to the magnetic moment. This amplifies the precession of the magnetic moment, and when the precession reaches criticality, the direction of the magnetic moment is reversed from one side to the other side of the first axis. Since the magnetic moment is magnetically most stable in a state where the magnetic moment faces a direction along the first axis, the magnetic moment in which the precession has reached the criticality is reversed at a high speed from one side to the other side of the first axis. That is, the magnetic moment instantaneously faces a direction along the second axis in the reversal process. At this time, the generating portion detects a state in which the magnetic moment instantaneously faces the direction along the second axis, and generates a pulse rising when the magnetic moment instantaneously faces the second axis. As a result, a pulse with a short pulse width can be generated.

In one embodiment, in a cross-sectional shape of the spin rotor in an in-plane direction of the substrate, a distance between two points that are most separated from each other in a direction of the second axis in an outline of the cross-sectional shape may be longer than a distance between two points that are most separated from each other in a direction intersecting with the second axis in the outline of the cross-sectional shape, the second axis faces the axes direction of the channel portion. Alternatively, in one embodiment, the cross - sectional shape of the spin rotor in the in-plane direction of the substrate is an elliptical shape, and the second axis is a major axis of the elliptical shape. In such a configuration, the direction of the magnetic moment of when the magnetic moment of the spin rotor is reversed is restricted. That is, since the second axis orthogonal to the first axis can be specified in one direction, the state in which the magnetic moment of the spin rotor faces the direction along the second axis can be easily detected.

In one embodiment, the spin injector may have magnetization in a direction parallel to the first axis. In such a configuration, the direction of the spin flowing into the channel portion from the spin injector and the direction of the spin flowing from the channel portion to the spin rotor are the same. Therefore, the spin current having a spin state in the same direction as a magnetization direction of the spin injector flows into the spin rotor. Contribution of the spin-transfer torque acting on the magnetic moment of the spin rotor becomes larger than a case where spin flowing into the magnetic moment of the spin rotor with an angle. Therefore, the magnetic moment of the spin rotor can efficiently receive the spin-transfer torque.

In one embodiment, the first axis may be a perpendicular-to-substrate direction of the substrate. For example, in a case of arraying a plurality of spin rotors on a substrate, the magnetic moment can be arrayed with higher density with a spin rotor having a magnetic moment in a perpendicular-to-substrate direction of the substrate than a spin rotor having a magnetic moment in an in-plane direction.

In one embodiment, the generating portion may detect a leaked magnetic field of when the magnetic moment of the spin rotor faces the direction along the second axis. In this case, a GMR element, a TMR element, or the like can be employed as the generating portion.

In one embodiment, the generating portion may include an intermediate layer provided in contact with the spin rotor, and made of a non-ferromagnetic metal or an insulator, a fixed layer provided in contact with the intermediate layer, and having a magnetic moment fixed in a direction along the second axis, and an acquiring portion configured to acquire a current flowing between the spin rotor and the fixed layer or a voltage generated between the spin rotor and the fixed layer. In this case, the spin rotor can function as a free layer of a so-called spin valve element. Therefore, a state of the magnetic moment in the spin rotor can be detected.

### Advantageous Effects of Invention

According to aspects and various embodiments of the present invention, a pulse generation device capable of generating a pulse with a short pulse width can be provided.

### Brief Description of Drawings

FIG. 1 is a perspective view of a pulse generation device according to an embodiment.
FIG. 2 is a partially enlarged view of a pulse generation device according to an embodiment.
FIG. 3 is a schematic diagram illustrating an operation principle of a spin generation device according to an embodiment.
FIG. 4 is a schematic diagram illustrating a pulse generated by a spin generation device according to an embodiment.

### Description of Embodiments

Hereinafter, embodiments will be specifically described with reference to the appended drawings. Note that, in the description of drawings, the same element is denoted with the same reference sign, and overlapping description is omitted. Further, dimension ratios of the drawings do not necessarily accord with the description.

The pulse generation device according to the present embodiment is a pulse generation device to which a so-called spin valve structure is applied, and is employed as, for example, a nanoscale pulse generation device.

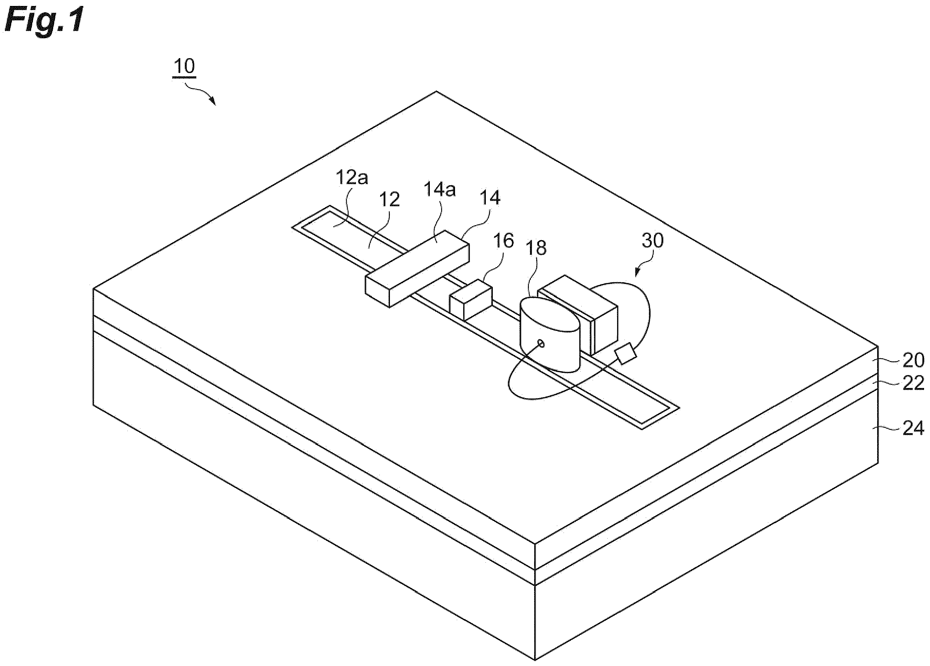

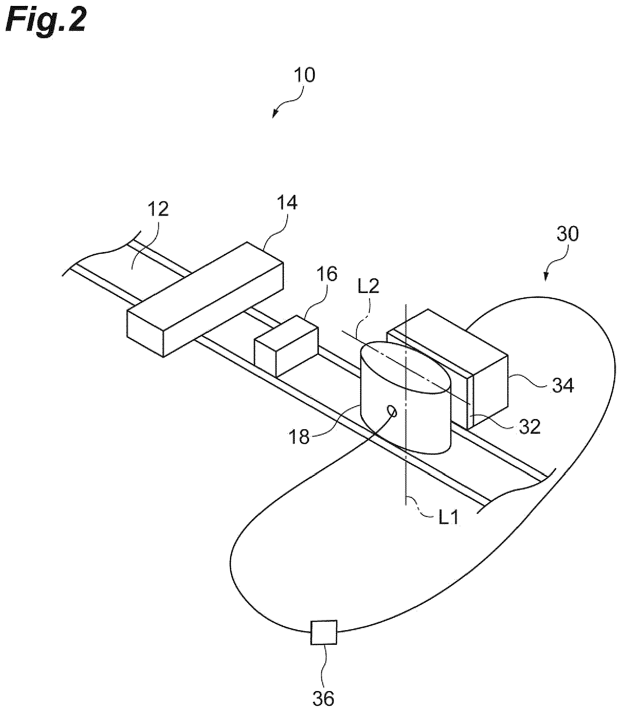

FIG. 1 is a perspective view of a pulse generation device according to an embodiment. FIG. 2 is a partially enlarged view of a pulse generation device according to an embodiment. As illustrated in FIGS. 1 and 2, a pulse generation device 10 includes, for example, a substrate 24, a channel portion 12, a spin injector 14, a spin rotation control portion 16, a spin rotor 18, and a generating portion 30. Here, a spin valve structure is formed on the substrate 24, in which the spin injector 14 made of a ferromagnetic body and the spin rotor 18 made of a ferromagnetic body are bridged by the channel portion 12 made of a nonmagnetic body. In the spin valve structure, the spin injector 14 and the spin rotor 18 are provided separated from each other on the substrate 24, and the channel portion 12 is arranged between the spin injector 14 and the spin rotor 18. Noted that the pulse generation device 10 may not include the spin rotation control portion 16.

As the substrate 24, a semiconductor substrate is used, for example. The spin injector 14 and the spin rotor 18 can be formed of a magnetic metal such as Fe or NiFe. The channel portion 12 can be formed of a semiconductor material such as Si or gallium arsenide (GaAs), or a nonmagnetic metal such as Ag or Cu. Hereinafter, a case in which the channel portion 12 is formed of the semiconductor material will be described.

The channel portion 12 is provided on the substrate 24. The channel portion 12 is a linear member, and is arranged such that its axis direction faces an in-plane direction of the substrate 24. The channel portion 12 is formed by processing a semiconductor layer 20 layered on the substrate 24 in a mesa manner.

The line width of the channel portion 12 is 10 µm or less, for example. Further, the line width of the channel portion 12 may be 0.1 µm or more, for example. In a case where a two-dimensional electronic gas layer 22 is formed between the substrate 24 and the semiconductor layer 20, the channel portion 12 may be formed by processing the two-dimensional electronic gas layer 22 and the semiconductor layer 20 in a mesa manner. For example, in a case where a GaAs substrate is used as the substrate 24 and the semiconductor layer 20 is formed by doping the substrate 24 with electrons, the two-dimensional electronic gas layer 22 is formed between the semiconductor layer 20 and the substrate 24.

The spin injector 14 is provided on the substrate 24. As a more specific example, the spin injector 14 is provided in contact (directly joined) with an upper surface of the channel portion 12. The spin injector 14 is a linear member, and has an approximately rectangular shape. The spin injector 14 is arranged such that its axis direction faces the in-plane direction of the substrate 24. As a more specific example, the spin injector 14 is arranged such that its axis direction intersects with the axis direction of the channel portion 12. An area where the spin injector 14 and the channel portion 12 come in contact with each other is a spin injection area (spin injection position). Further, the spin injector 14 has a magnetic moment (spontaneous magnetization) facing a perpendicular-to-substrate direction of the substrate 24 (a direction parallel to a first axis L1 described below). In the present specification, the magnetic moment means an overall magnetic moment that macroscopically captures a magnetic moment of electrons unless otherwise specified. The line width of the spin injector 14 is 10 µm or less, for example. Further, the line width of the spin injector 14 may be 0.1 µm or more, for example.

The spin rotor 18 is provided on the substrate 24. As a more specific example, the spin rotor 18 is provided in contact (directly joined) with the upper surface of the channel portion 12. The spin rotor 18 is arranged separated from the spin injector 14. The distance (separation distance) between the spin rotor 18 and the spin injector 14 is shorter than a spin diffusion length. The spin diffusion length depends on the magnetic material to be configured, and is 1 µm or less, for example. In this case, the separation distance is at least a distance shorter than 1 µm.

The spin rotor 18 is, for example, a columnar member extending in the perpendicular-to-substrate direction of the substrate 24, and the cross-sectional shape of the spin rotor 18 in the in-plane direction of the substrate 24 is an elliptical shape. As illustrated in FIG. 2, hereinafter, the axis of the spin rotor 18 extending in the perpendicular-to-substrate direction of the substrate 24 is referred to as a first axis L1 (first axis), and the major axis of the ellipse of the cross-sectional shape of the spin rotor 18 is referred to as a second axis L2 (second axis). For example, the spin rotor 18 may be arranged such that the second axis L2 faces the axis direction of the channel portion 12 (see FIG. 2).

In the cross-sectional shape of the spin rotor 18, the length in a major axis direction (in a direction of the second axis L2) may be 0.1 µm or more, for example. Further, the cross-sectional shape of the spin rotor 18 may have the length in the major axis direction of, for example, 10 µm or less. Further, in the cross-sectional shape of the spin rotor 18, the length in a minor axis direction (a direction orthogonal to the second axis L2) is shorter than the length in the major axis direction, and may be 0.1 µm or more, for example. The cross - sectional shape of the spin rotor 18 may be formed such that the length in the minor axis direction becomes smaller than the line width of the channel portion 12.

For example, the spin rotor 18 has a magnetic moment (spontaneous magnetization) along the first axis L1 extending in the perpendicular-to-substrate direction of the substrate 24 (see FIG. 2). The spin rotor 18 has magnetic anisotropy in which the direction of the first axis L1 is an easy axis of magnetization. In other words, the magnetic moment of the spin rotor 18 becomes a magnetically most stable energy state (perpendicular magnetic anisotropy) when the magnetic moment faces the direction along the first axis L1. The spin rotor 18 can realize the perpendicular magnetic anisotropy by shape magnetic anisotropy by the columnar shape. Alternatively, the spin rotor 18 may realize the perpendicular magnetic anisotropy by crystal magnetic anisotropy. In this case, for example, the spin rotor 18 may be formed of a magnetic metal having an L1₀ crystal structure such as FePt, or may be formed as a columnar member having a multilayer structure such as a (Co/Pt) multilayer film or CoFeB/MgO.

Further, in a case where the cross - sectional shape of the spin rotor 18 in the in-plane direction of the substrate 24 is an elliptical shape, the shape magnetic anisotropy is generated in the direction of the second axis L2 that is the major axis of the ellipse. Therefore, when the magnetic moment of the spin rotor 18 faces the in-plane direction of the substrate 24 in a reversal process, the magnetic moment becomes the magnetically most stable energy state when the magnetic moment faces the direction along the second axis L2 in the in-plane direction of the substrate 24. That is, the second axis L2 is the easy axis of magnetization in the in-plane direction of the substrate 24. In this manner, by setting the easy axis of magnetization in the in-plane direction of the substrate 24, detection of the direction of the magnetic moment by the generating portion 30 described below can be facilitated. Note that the magnetic anisotropy in the direction of the first axis L1 is larger than the magnetic anisotropy in the direction of the second axis L2. Therefore, the magnetic energy of when the magnetic moment faces the direction of the first axis L1 is smaller than the magnetic energy of when the magnetic moment faces the direction of the second axis L2.

A terminal portion 14a for current or voltage application is formed in one end portion of the spin injector 14, and a terminal portion 12a for current or voltage application is formed in one end portion (an end portion closer to the spin injector 14, of both end portions) of the channel portion 12. Spin is injected by application of a current or a voltage to between the terminal portion 14a and the terminal portion 12a.

The spin rotation control portion 16 includes a voltage control unit and a voltage application terminal (not illustrated). The spin rotation control portion 16 is connected to the channel portion 12. For example, the spin rotation control portion 16 is directly joined with an area on an upper surface of the channel portion 12 and with an area positioned between the spin injector 14 and the spin rotor 18. The spin rotation control portion 16 is configured to be able to apply an electric field or a magnetic field to the channel portion 12 to control a rotating direction of the spin of the channel portion 12. The spin rotation control portion 16 exhibits an approximately rectangular parallelepiped, and a width in a direction orthogonal to a longitudinal direction of the channel portion 12 is 10 µm or less, for example. Note that, here, the spin rotation control portion 16 is formed such that the width in the direction orthogonal to the longitudinal direction of the channel portion 12 becomes the line width of the channel portion 12 or less.

When the magnetic moment of the spin rotor 18 is reversed from a state in which the magnetic moment faces one side of the first axis L1 to a state in which the magnetic moment faces the other side of the first axis L1, the generating portion 30 detects the state in which the magnetic moment of the spin rotor 18 faces the direction along the second axis L2 orthogonal to the first axis L1. The generating portion 30 detects, for example, a physical quantity or a physical property value that varies according to the direction of the magnetic moment of the spin rotor 18. For example, the generating portion 30 detects a current value, a voltage value, or a resistance value depending on the direction of the magnetic moment, by using the giant magnetoresistance (GMR) effect or the tunnel magnetic resistance (TMR) effect.

As a specific example, the generating portion 30 includes an intermediate layer 32, a fixed layer 34, and an acquiring portion 36. The intermediate layer 32 is provided in contact with the spin rotor 18, and is made of a non-ferromagnetic metal or an insulator. The fixed layer 34 is provided in contact with the intermediate layer 32, and the magnetic moment is fixed in a direction along the second axis L2. The magnetic moment is fixed by exchange coupling with a pinning layer made of an antiferromagnetic body, for example. That is, ferromagnetic tunnel junction in which the spin rotor 18 and the fixed layer 34 interposes the intermediate layer 32 therebetween. Therefore, the resistance value between the spin rotor 18 and the fixed layer 34 varies depending on the direction of the magnetic moment of the spin rotor 18 and the direction of the magnetic moment of the fixed layer 34.

The acquiring portion 36 acquires a current flowing between the spin rotor 18 and the fixed layer 34 or a voltage caused between the spin rotor 18 and the fixed layer 34. The generating portion 30 detects a state in which the magnetic moment of the spin rotor 18 and the magnetic moment of the fixed layer 34 become parallel or antiparallel on the basis of the acquisition result (the current value, the voltage value, or the resistance value) of the acquiring portion 36. In other words, when the magnetic moment of the spin rotor 18 is reversed from the state in which the magnetic moment faces one side of the first axis L1 to the state in which the magnetic moment faces the other side of the first axis L1, the generating portion 30 can detect the state in which the magnetic moment of the spin rotor 18 faces the direction along the second axis L2 (the state in which the magnetic moment becomes parallel or antiparallel). For example, the generating portion 30 detects the state in which the magnetic moment becomes parallel or antiparallel, by detecting a change point or a singular point of the current value, the voltage value, or the resistance value acquired by the acquiring portion 36. As a result, the generating portion 30 generates a pulse that rises when the magnetic moment of the spin rotor 18 instantaneously faces the direction along the second axis L2.

The pulse generation device 10 having the above configuration is operated as follows. First, a current is applied to between the terminal portion 14a of the spin injector 14 and the terminal portion 12a of the channel portion 12. As a result, a spin current in the same direction as a magnetization direction of the spin injector 14 is injected into the channel portion 12. The spin injected into the channel portion 12 is diffused to both end portions of the channel portion 12. The spin current without accompanying electric charges is generated from the spin injector 14 side toward the spin rotor 18 side. The spin current flowing in the channel portion 12 carries the spin angular momentum to the magnetic moment of the spin rotor 18. The method of injecting the spin current into the channel portion 12 is not limited to a non-local technique.

The direction of the spin flowing in the channel portion 12 may be controlled by an applied voltage of the spin rotation control portion 16. For example, the spin of the spin current flowing in the channel portion 12 performs precession by spin-orbit interaction, and this spin-orbit interaction may be controlled by the electric field by the voltage applied by the spin rotation control portion 16.

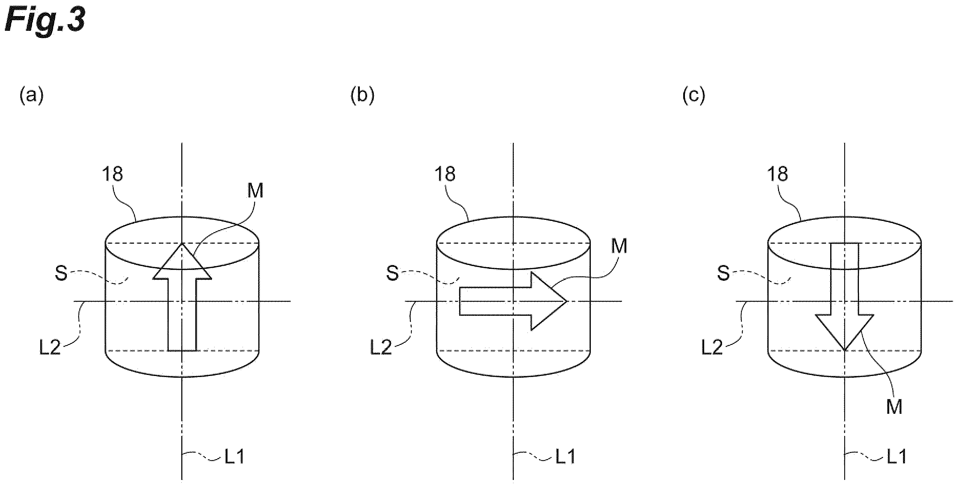

Here, reversal of the magnetic moment in the spin rotor 18 will be described with reference to FIG. 3. FIG. 3 is a schematic diagram illustrating an operation principle of the pulse generation device 10 according to an embodiment. The spin rotor 18 and a magnetic moment M (white arrow in the figure) of the spin rotor 18 are illustrated in (a) of FIG. 3 to (c) of FIG. 3. (a) of FIG. 3 illustrates a state of the magnetic moment M before the precession is excited. (b) of FIG. 3 illustrates a state in which the magnetic moment M faces the direction along the second axis L2 in a relaxation process of the magnetic moment M. (c) of FIG. 3 illustrates a state in which the reversed magnetic moment M faces again the direction along the first axis L1.

As described above, the first axis L1 of the spin rotor 18 is the easy axis of magnetization, and the magnetic moment M faces the direction along the first axis L1 (see (a) of FIG. 3). By the injection of the spin current, the spin angular momentum is transmitted and the precession of the magnetic moment of electrons is excited. From a macroscopic viewpoint, it can be said that the precession of the magnetic moment M is excited. When the precession of the magnetic moment M is excited, the magnetic moment M performs the precession around the first axis L1. From the law of conservation of angular momentum between the inflow spin and the magnetic moment M, a force is applied to the magnetic moment M in the direction of reversing the magnetic moment M. The precession of the magnetic moment M is amplified and when the precession reaches the criticality, the magnetic moment M of the spin rotor 18 is reversed at a high speed from the state in which the magnetic moment M faces one side of the first axis L1 to the state in which the magnetic moment M faces the other side of the first axis L1. At this time, as illustrated in (b) of FIG. 3, the magnetic moment M faces the direction of easy axis of magnetization in the in-plane direction of the substrate 24, that is, the direction along the second axis L2. In this way, the magnetic moment M is rotated in a plane S including the first axis L1 and the second axis L2. Then, as illustrated in (c) of FIG. 3, the magnetic moment M again becomes along the first axis L1.

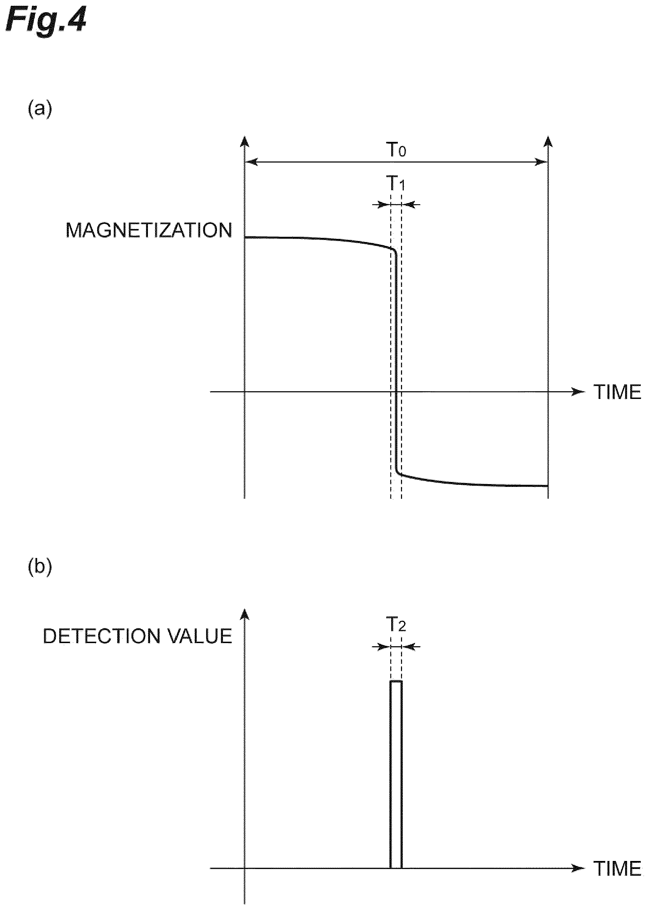

Next, the method of detecting the direction of the magnetic moment M of the spin rotor 18 by the generating portion 30 will be described in detail. FIG. 4 is a schematic diagram illustrating a pulse generated by a spin generation device according to an embodiment. (a) of FIG. 4 is a graph illustrating temporal change in the magnetization direction of the magnetic moment M in the spin rotor 18. The horizontal axis of (a) of FIG. 4 represents time, and the vertical axis of (a) of FIG. 4 represents magnitude of magnetization. (a) of FIG. 4 illustrates the magnetization of the magnetic moment M in an upward direction in the perpendicular-to-substrate direction of the substrate 24 as a positive value, and the magnetization of the magnetic moment in a downward direction in the perpendicular-to-substrate direction of the substrate 24 as a negative value. That is, in (a) of FIG. 4 illustrates the time change in the magnetization direction at a measurement time T0. The measurement time TO is the time from when the spin flows into the spin rotor 18 and the magnetic moment M is reversed from the magnetically stable state to when the magnetic moment M reaches the magnetically stable state again. The measurement time TO is, for example, several n (nano) seconds. (b) of FIG. 4 is a graph illustrating time change of a detection value acquired by the acquiring portion 36. The horizontal axis of (b) of FIG. 4 represents time, and the vertical axis of (b) of FIG. 4 represents the detection value acquired by the acquiring portion 36. That is, (b) of FIG. 4 illustrates the time change of the detection value at the same measurement time TO as (a) of FIG. 4. The detection value is a current value as an example.

When measurement is started, the acquiring portion 36 measures the direction of the magnetic moment M of the spin rotor 18. As illustrated in (a) of FIG. 4, the acquiring portion 36 detects a state in which the magnetic moment M of the spin rotor 18 faces the direction along the first axis L1. At this time, the magnetic moment M of the spin rotor 18 is magnetically stable in the state of facing the direction along the first axis L1 (see (a) of FIG. 3). When the spin is injected, the magnetic moment M receives the spin angular momentum, and the precession of the magnetic moment M is started. Then, when a predetermined time has passed from the spin injection, the precession of the magnetic moment M is amplified. As the precession of the magnetic moment M is amplified, the detected component of the magnetic moment M in the direction of the first axis L1 is gradually decreased.

When the precession reaches the criticality, the magnetic moment M of the spin rotor 18 is reversed at a time T1, passes through the state of facing the direction along the second axis L2, and again becomes the state of facing the direction along the first axis L1 and is magnetically stable (see (b) and (c) of FIG. 3). In the reversal process, the magnetic moment M is reversed at high speed from one side to the other side of the direction of the first axis L1. The time T1 is, for example, several p (pico) seconds. At this time, as illustrated in (b) of FIG. 4, a state in which the magnetic moment M faces the direction along the second axis L2 is detected by the acquiring portion 36. The reversing speed of the magnetic moment M in the reversal process depends on, for example, the damping constant of the ferromagnetic material. A time T2 in the state in which the magnetic moment M faces the direction along the second axis L2 is, for example, several p (pico) seconds. Therefore, the detection value detected by the acquiring portion 36 becomes a pulse with a short width of a rising component or a falling component of a waveform. As described above, the detection value detected by the acquiring portion 36 may just include, for example, the rising component or the falling component of a waveform. In the present embodiment, the pulse detected by the acquiring portion 36 is an approximately rectangular wave, and includes a rising component rising at about 90 degrees and a falling component falling at about 90 degrees. Therefore, the generating portion 30 generates a rectangular wave pulse having a rectangular or square shape. The waveform of the detection value detected by the acquiring portion 36 is not limited to the rectangular wave. That is, the waveform of the detection value detected by the acquiring portion 36 may be a triangular wave or a sawtooth wave. The acquiring portion 36 detects the physical quantity or physical property value that varies according to the direction of the magnetic moment of the spin rotor 18, whereby the generating portion 30 can generate a pulse rising when the magnetic moment of the spin rotor 18 instantaneously faces the direction along the second axis L2.

As described above, according to the pulse generation device 10 of the present embodiment, when a current or a voltage is applied to the spin injector 14 and the channel portion 12, the spin current toward the spin rotor 18 is generated in the channel portion 12. The spin current flowing in the channel portion 12 acts on the magnetic moment M of the spin rotor 18 as spin-transfer torque. That is, when the precessing magnetic moment M receives the spin angular momentum from the spin current, a rotational force is applied to the magnetic moment M. As a result, the precession of the magnetic moment M is amplified, and when the precession reaches the criticality, the direction of the magnetic moment M is reversed from one side of the first axis L1 to the other side. Since the magnetic moment M is magnetically most stable state in the state of facing the direction along the first axis L1, the magnetic moment M in which the precession has reached the criticality is reversed at a high speed from one side to the other side of the first axis L1. That is, the magnetic moment M instantaneously faces the direction along the second axis L2 in the reversal process. At this time, the generating portion 30 detects a state in which the magnetic moment M instantaneously faces the second axis L2, and generates a pulse rising when the magnetic moment M instantaneously faces the direction along the second axis L2. As a result, a pulse with a short pulse width can be generated.

Further, according to the pulse generation device 10 of an embodiment, the cross - sectional shape of the spin rotor 18 in the in-plane direction of the substrate 24 is the elliptical shape, and the second axis L2 is the major axis of the elliptical shape. Therefore, the direction of the magnetic moment M of the rotor 18 of when the magnetic moment M is reversed is restricted. That is, the second axis L2 orthogonal to the first axis L1 can be specified to one direction, and thus the state in which the magnetic moment M of the spin rotor 18 faces the direction along the second axis L2 can be easily detected. However, the spin rotor 18 is not limited thereto, and the spin rotor 18 may have a dot shape or a columnar shape. In this case, by performing control in an external field, the direction of the spin can be controlled and can be detected on a relaxing plane.

Further, according to the pulse generation device 10 of an embodiment, the spin injector 14 has magnetization in the direction parallel to the first axis L1, and thus the direction of the spin flowing from the spin injector 14 into the channel portion 12 and the direction of the spin flowing from the channel portion 12 to the spin rotor 18 becomes the same. Therefore, the spin current having a spin state in the same direction as the magnetization direction of the spin injector 14 flows into the spin rotor 18. Contribution of the spin-transfer torque acting on the magnetic moment M of the spin rotor 18 becomes larger than a case where spin flowing into the magnetic moment M of the spin rotor 18 with an angle. Therefore, the magnetic moment M of the spin rotor 18 can efficiently receive the spin-transfer torque.

Further, according to the pulse generation device 10 of an embodiment, the spin rotor 18 having the magnetic moment M is provided in the perpendicular-to-substrate direction of the substrate 24. Therefore, in a case of arraying a plurality of spin rotors on a substrate, the magnetic moment can be arrayed at higher density than a spin rotor having a magnetic moment in the in-plane direction of the substrate 24.

Further, according to the pulse generation device 10 of an embodiment, the generating portion 30 can cause the spin rotor 18 to function as a free layer of a so-called spin valve element. With the function, the state of the magnetic moment M in the spin rotor 18 can be detected.

Further, according to the pulse generation device 10 of an embodiment, the channel portion 12 is formed of the two-dimensional electronic gas layer 22 and the semiconductor layer 20. Therefore, the spin is supplied from the two-dimensional electronic gas layer 22. Therefore, propagation of the spin angular momentum in the channel portion 12 can be efficiently performed.

Further, according to the pulse generation device 10 of an embodiment, the spin rotor 18 is formed such that the width in the direction orthogonal to the longitudinal direction of the channel portion 12 becomes the line width of the channel portion 12 or less. Therefore, the spin angular momentum of the channel portion 12 can be efficiently propagated to the spin rotor 18.

Further, according to the pulse generation device 10 of an embodiment, the terminal portion 12a for current application is formed at the end portion of the channel portion 12, the end portion being close to the spin injector 14. Therefore, the spin current without accompanying a flow of electric charges is generated and the magnetic moment of the spin rotor 18 can be rotated. Therefore, generation of Joule heat can be suppressed, and thus the pulse generation device 10 that can be stably operated can be realized.

The above-described embodiment describes an example of the pulse generation device 10 according to the present invention, and the present invention is not limited to the pulse generation device 10 according to the embodiment, and may be modified or applied to another configuration.

### [Modification 1]

As the pulse generation device 10 according to the embodiment, an example in which the spin rotor 18 has the perpendicular magnetic anisotropy by the shape magnetic anisotropy has been described. However, the embodiment is not limited to the example. The spin rotor 18 may realize perpendicular magnetic anisotropy by crystal magnetic anisotropy. In this case, the spin rotor 18 may be formed by epitaxially growing a magnetic material having an L1₀ crystal structure such as an L1₀ type FeNi ordered alloy or FePt, or may be formed by epitaxially growing a multilayer structure such as a (Co/Pt) multilayer film or CoFeB/MgO. With the formation, an easy axis of magnetization caused by the crystal magnetic anisotropy can be regarded as the first axis L1. Even in such a case, a pulse with a short pulse width can be generated using the reversal of the magnetic moment M.

### [Modification 2]

As the pulse generation device 10 according to the embodiment, an example in which the cross-sectional shape of the spin rotor 18 in the in-plane direction of the substrate 24 is an elliptical shape has been described. However, the present embodiment is not limited to the example. In the cross - sectional shape of the spin rotor 18 in the in-plane direction of the substrate, a distance between two points that are most separated from each other in a direction of the second axis L2 in an outline of the cross-sectional shape may be longer than a distance between two points that are most separated from each other in a direction intersecting with the second axis L2 in the outline of the cross-sectional shape. The direction intersecting with the second axis L2 may be a direction orthogonal to the second axis L2. Since the magnetic moment M is more likely to face the direction of the second axis L2 due to the shape magnetic anisotropy, the direction of the magnetic moment M in the reversal process can be controlled. Therefore, the second axis L2 can be specified to one direction, and thus the state in which the magnetic moment M of the spin rotor 18 faces the direction along the second axis L2 can be easily detected.

### [Modification 3]

As the pulse generation device 10 according to the embodiment, a case of detecting the reversal of the magnetic moment M as the magnetization that is the sum of the magnetic moment per unit volume has been described. However, the embodiment is not limited to the example. For example, the local magnetic moment M of the spin rotor 18 may be observed. In this case, for example, the reversal of the magnetic moment M can be detected using local magnetization of the spin rotor 18.

### [Modification 4]

As the pulse generation device 10 according to the embodiment, an example in which the spin rotor 18 has the perpendicular magnetic anisotropy has been described. However, the embodiment is not limited to the example. For example, the spin rotor 18 may have in-plane magnetic anisotropy. In this case, the first axis L1 becomes the in-plane direction of the substrate 24. At this time, the spin injector 14 has a magnetic moment facing the in-plane direction of the substrate 24. In a case where the spin injector 14 and the spin rotor 18 have magnetization in the in-plane direction, the magnetic moment of the fixed layer 34 included in the generating portion 30 is fixed parallel or antiparallel to the perpendicular-to-substrate direction. With this configuration, the resistance value between the spin rotor 18 and the fixed layer 34 varies depending on the direction of the magnetic moment of the spin rotor 18 and the direction of the magnetic moment of the fixed layer 34. Therefore, when the magnetic moment of the spin rotor 18 is reversed from a state in which the magnetic moment faces one side of the first axis L1 to a state in which the magnetic moment faces the other side of the first axis L1, the acquiring portion 36 included in the generating portion 30 can detect the state in which the magnetic moment of the spin rotor 18 faces the direction along the second axis L2.

### [Modification 5]

As the pulse generation device 10 according to the embodiment, an example in which the generating portion 30 causes the spin rotor 18 to function as a free layer of a so-called spin valve element to detect the direction of the magnetic moment M has been described. However, the embodiment is not limited to the example. For example, the generating portion 30 may detect the direction of the magnetic moment M using the magneto-optical effect. Alternatively, a leaked magnetic field of when the magnetic moment M of the spin rotor 18 faces the direction along the second axis L2 may be detected. For example, the generating portion 30 may include a known leaked magnetic field detecting portion used for a magnetic head or the like and the detecting portion may just be arranged around the spin rotor 18. The detecting portion may just be arranged within a range where the leaked magnetic field of the spin rotor 18 is transmitted, and is arranged in a range of several tens of nm or less from the spin rotor 18, for example.

### [Modification 6]

The pulse generation device 10 according to the embodiment may be manufactured through lamination and etching on the substrate 24. In this case, the pulse generation device 10 can be easily manufactured by a conventional semiconductor technology. Further, the spin diffusion length of a nonmagnetic metal is about several hundreds of nm at room temperature, whereas the spin diffusion length of a semiconductor is longer by one digit or more. Therefore, by forming the channel portion 12 with a semiconductor material, the spin injector 14 and the spin rotor 18 can be formed separated from each other, as compared with a case of employing another nonmagnetic material. Therefore, strict processing accuracy is not required in a manufacturing process, as compared with the case of employing another nonmagnetic material, and the pulse generation device 10 can be easily manufactured.

### [Modification 7]

The pulse generation device 10 can also be used as a part of an oscillator (a part for oscillator), for example. The pulse generation device 10 can be used as a part of an oscillator by continuously generating pulses. The oscillator using the pulse generation device 10 may use the magnetoresistance effect in which a current flows only when directions of two magnetic moments match, for example. A structure to oscillate according to the rotation speed of the spin rotor 18 may be realized by the magnetoresistance effect using the direction of the magnetic moment of a ferromagnetic body brought into contact with the spin rotor 18 via a nonmagnetic member and the direction of the magnetic moment of the spin rotor 18.

### [Modification 8]

As the pulse generation device 10 according to the embodiment, an example in which the spin injector 14, the spin rotation control portion 16, and the spin rotor 18 are directly joined with the channel portion 12 has been described. However, at least one of the spin injector 14, the spin rotation control portion 16, and the spin rotor 18 may be joined with the channel portion 12 through an insulating layer. Even with such a configuration, the configuration can function as the pulse generation device 10.

### [Modification 9]

As the pulse generation device 10 according to the embodiment, an example in which the spin injector 14 and the spin rotor 18 are arranged above the channel portion 12 has been described. However, the spin injector 14 and the spin rotor 18 may be arranged in any manner as long as at least a part of the spin injector 14 and the spin rotor 18 is in contact with the channel portion 12. That is, the spin injector 14 and the spin rotor 18 may be arranged at a side of the channel portion 12. Further, the width of the spin rotor 18 may be the line width of the channel portion 12 or more.

### [Modification 10]

As the pulse generation device 10 according to the embodiment, an example in which the magnetization reversal is performed using a spin current flowing in the in-plane direction has been described. However, the embodiment is not limited to the example. For example, magnetization reversal using a spin-transfer torque may be realized by causing a current to flow in the perpendicular-to-substrate direction into a member that configures ferromagnetic tunnel junction having magnetization in the perpendicular-to-substrate direction.

### [Modification 11]

As the pulse generation device 10 according to the embodiment, an example in which the spin current without accompanying a flow of electric charges is generated by a so-called non-local technique to rotate the spin rotor 18 has been described. However, the embodiment is not limited to the example. The spin rotor 18 may be rotated by forming the terminal portion 12a for current application in an end portion of the channel portion 12, the end portion close to the spin rotor 18, and causing a current to flow from the terminal portion 14a to the terminal portion 12a to generate a spin current in the channel portion 12. That is, a spin current accompanying a flow of electric charges may be generated in the channel portion 12 by a so-called local technique to rotate the magnetic moment of the spin rotor 18. In this case, current density can be made larger than the case of the non-local technique, and thus the spin torque can be made large. Therefore, the magnetic moment of the spin rotor 18 can be efficiently rotated.

### [Modification 12]

As the pulse generation device 10 according to the embodiment, a case in which a pulse is generated by one pulse generation device has been described. However, the embodiment is not limited to the example. For example, a configuration in which a plurality of pulse generation devices 10 is arrayed and pulse waveforms are continuously generated may be employed. In this case, the continuous pulse may be detected by each of the generating portions 30 of the plurality of pulse generation devices 10, or may be detected by a generating portion 30 common to the plurality of pulse generation devices 10. With such a configuration, the continuous pulse can be generated, and thus can be used as a synchronization signal of an electronic circuit.

### [Modification 13]

As the pulse generation device 10 according to the embodiment, the description has been given to include a case in which the configuration members of the pulse generation device 10 are members having the sizes in nano order. However, the configuration members may be formed in micro order to configure a micro-scale pulse generation device.

### Industrial Applicability

The pulse generation device 10 has industrial applicability as follows. The pulse generation device 10 can be used as a pulse generation device in the fields such as micro-electro-mechanical systems (MEMS) or nano-electro-mechanical systems (NEMS). Further, the pulse generation device 10 can be used as an equipment part in, for example, the electronic field, the electric field, and the medical related field. The pulse generation device 10 can be incorporated in a semiconductor device.

### Reference Signs List

10...Pulse generation device, 12...Channel portion, 14...Spin injector, 16...Spin rotation control portion, 18...Spin rotor, 20...Semiconductor layer, 22...Two-dimensional electronic gas layer, 24...Substrate, 30...Generating portion, 32...Intermediate layer, 34...Fixed layer, 36...Acquiring portion, L1...First axis, L2...Second axis, M...Magnetic moment

## Claims

1. A pulse generation device (10) comprising:
a substrate (24);
a spin injector (14) provided over the substrate (24) and made of a ferromagnetic body;
a spin rotor (18) provided over the substrate (24), made of a ferromagnetic body, and having magnetic anisotropy in which a direction of a first axis (L1) becomes an easy axis of magnetization;
a channel portion (12) made of a nonmagnetic body, and joined with the spin injector (14) and the spin rotor (18) directly or via an insulating layer; and
**characterized by**
a generating portion (30) configured to detect a physical quantity or a physical property value that varies according to a direction of a magnetic moment (M) of the spin rotor (18) when the magnetic moment (M) of the spin rotor (18) is reversed from one side of the first axis (L1) to the other side of the first axis (L1), and configured to generate a pulse based on the physical quantity or property value that corresponds to a state in which the magnetic moment (M) of the spin rotor (18) faces a direction along a second axis (L2) orthogonal to the first axis (L1).

2. The pulse generation device (10) according to claim 1, wherein, in a cross-sectional shape of the spin rotor (18) in an in-plane direction of the substrate (24), a distance between two points that are most separated from each other in a direction of the second axis (L2) in an outline of the cross-sectional shape is longer than a distance between two points that are most separated from each other in a direction intersecting with the second axis (L2) in the outline of the cross-sectional shape, the second axis (L2) faces the axis direction of the channel portion (12).

3. The pulse generation device (10) according to claim 1 or 2, wherein a cross - sectional shape of the spin rotor (18) in an in-plane direction of the substrate (24) is an elliptical shape, and the second axis (L2) is a major axis of the elliptical shape.

4. The pulse generation device (10) according to any one of claims 1 to 3, wherein the spin injector (14) has magnetization in a direction parallel to the first axis (L1).

5. The pulse generation device (10) according to any one of claims 1 to 4, wherein the first axis (L1) is a perpendicular-to-substrate direction of the substrate (24).

6. The pulse generation device (10) according to any one of claims 1 to 5, wherein the generating portion (30) detects a leaked magnetic field of when the magnetic moment (M) of the spin rotor (18) faces the direction along the second axis (L2).

7. The pulse generation device (10) according to any one of claims 1 to 5, wherein
the generating portion (30) includes
an intermediate layer (32) provided in contact with the spin rotor (18), and made of a non-ferromagnetic metal or an insulator,
a fixed layer (34) provided in contact with the intermediate layer (32), and having a magnetic moment (M) fixed in the direction along the second axis (L2), and
an acquiring portion (36) configured to acquire a current flowing between the spin rotor (18) and the fixed layer (34) or a voltage generated between the spin rotor (18) and the fixed layer (34).

## Patentansprüche

1. Pulserzeugungsvorrichtung (10), umfassend:
ein Substrat (24);
einen Spin-Injektor (14), welcher an dem Substrat (24) bereitgestellt und aus einem ferromagnetischen Körper hegestellt ist;
einen Spin-Rotor (18), welcher an dem Substrat (24) bereitgestellt ist, aus einem ferromagnetischen Körper hergestellt ist und eine magnetische Anisotropie aufweist, in welcher eine Richtung einer ersten Achse (L1) eine einfache Magnetisierungsachse wird;
einen Kanalabschnitt (12), welcher aus einem nichtmagnetischen Körper hergestellt ist und mit dem Spin-Injektor (14) und dem Spin-Rotor (18) direkt oder über eine isolierende Schicht verbunden ist;
und **gekennzeichnet durch** einen Erzeugungsabschnitt (30), welcher dazu eingerichtet ist, eine physikalische Menge oder einen physikalischen Eigenschaftswert zu detektieren, welcher gemäß einer Richtung eines magnetischen Moments (M) des Spin-Rotors (18) variiert, wenn das magnetische Moment (M) des Spin-Rotors (18) von einer Seite der ersten Achse (L1) zu der anderen Seite der ersten Achse (L1) umgekehrt wird, und welcher dazu eingerichtet ist, einen Puls auf Grundlage der physikalischen Größe oder des Eigenschaftswerts zu erzeugen, welcher einem Zustand entspricht, in welchem das magnetische Moment (M) des Spin-Rotors (18) zu einer Richtung entlang einer zweiten Achse (L2) orthogonal zu der ersten Achse (L1) weist.

2. Pulserzeugungsvorrichtung (10) nach Anspruch 1, wobei in einer Querschnittsform des Spin-Rotors (18) in einer Richtung in der Ebene des Substrats (24) eine Distanz zwischen zwei Punkten, welche am meisten voneinander in einer Richtung der zweiten Achse (L2) in einem Umriss der Querschnittsform getrennt sind, länger ist als eine Distanz zwischen zwei Punkten, welche am meisten voneinander in einer Richtung getrennt sind, welche mit der zweiten Achse (L2) in dem Umriss der Querschnittsform schneidet, wobei die zweite Achse (L2) zu der Achsenrichtung des Kanalabschnitts (12) weist.

3. Pulserzeugungsvorrichtung (10) nach Anspruch 1 oder 2, wobei eine Querschnittsform des Spin-Rotors (18) in einer Richtung in der Ebene des Substrats (24) eine elliptische Form ist und die zweite Achse (L2) eine Hauptachse der elliptischen Form ist.

4. Pulserzeugungsvorrichtung (10) nach einem der Ansprüche 1 bis 3, wobei der Spin-Injektor (14) eine Magnetisierung in einer Richtung parallel zu der ersten Achse (L1) aufweist.

5. Pulserzeugungsvorrichtung (10) nach einem der Ansprüche 1 bis 4, wobei die erste Achse (L1) eine senkrecht-zum-Substrat-Richtung des Substrats (24) ist.

6. Pulserzeugungsvorrichtung (10) nach einem der Ansprüche 1 bis 5, wobei der Erzeugungsabschnitt (30) ein magnetisches Leckfeld, von wenn das magnetische Moment (M) des Spin-Rotors (18) zu der Richtung entlang der zweiten Achse (L2) weist, detektiert.

7. Pulserzeugungsvorrichtung (10) nach einem der Ansprüche 1 bis 5, wobei der Pulserzeugungsabschnitt (30) umfasst:
eine Zwischenschicht (32), welche in Kontakt mit dem Spin-Rotor (18) bereitgestellt und aus einem nicht-ferromagnetischen Metall oder einem Isolator hergestellt ist,
eine feste Schicht (34), welche in Kontakt mit der Zwischenschicht (32) bereitgestellt ist und ein magnetisches Moment (M) aufweist, welche in der Richtung entlang der zweiten Achse (L2) fest ist, und
einen Aufnahmeabschnitt (36), welcher dazu eingerichtet ist, einen Strom, welcher zwischen dem Spin-Rotor (18) und der festen Schicht (34) fließt, oder eine Spannung aufzunehmen, welche zwischen dem Spin-Rotor (18) und der festen Schicht (34) erzeugt wird.

## Revendications

1. Dispositif de génération d'impulsion (10) comprenant :
un substrat (24) ;
un injecteur de spin (14) prévu sur le substrat (24) et constitué d'un corps ferromagnétique ;
un rotor de spin (18) prévu sur le substrat (24), constitué d'un corps ferromagnétique, et ayant une anisotropie magnétique dans laquelle une direction d'un premier axe (L1) devient un axe aisé d'aimantation ;
une portion de canal (12) constituée d'un corps non magnétique, et jointe à l'injecteur de spin (14) et au rotor de spin (18) directement ou via une couche isolante ; et
**caractérisé par**
une portion de génération (30) configurée pour détecter une quantité physique ou une valeur de propriété physique qui varie selon une direction d'un moment magnétique (M) du rotor de spin (18) lorsque le moment magnétique (M) du rotor de spin (18) est inversé d'un côté du premier axe (L1) à l'autre côté du premier axe (L1), et configurée pour générer une impulsion d'après la quantité ou valeur de propriété physique qui correspond à un état dans lequel le moment magnétique (M) du rotor de spin (18) est en regard d'une direction selon un second axe (L2) orthogonal au premier axe (L1).

2. Dispositif de génération d'impulsion (10) selon la revendication 1, dans lequel, dans une forme en coupe du rotor de spin (18) dans une direction dans le plan du substrat (24), une distance entre deux points qui sont les plus séparés l'un de l'autre dans une direction du second axe (L2) dans un contour de la forme en coupe est plus longue qu'une distance entre deux points qui sont les plus séparés l'un de l'autre dans une direction coupant le second axe (L2) dans le contour de la forme en coupe, le second axe (L2) est en regard de la direction d'axe de la portion de canal (12).

3. Dispositif de génération d'impulsion (10) selon la revendication 1 ou 2, dans lequel une forme en coupe du rotor de spin (18) dans une direction dans le plan du substrat (24) est une forme elliptique, et le second axe (L2) est un grand axe de la forme elliptique.

4. Dispositif de génération d'impulsion (10) selon l'une quelconque des revendications 1 à 3, dans lequel l'injecteur de spin (14) a une aimantation dans une direction parallèle au premier axe (L1).

5. Dispositif de génération d'impulsion (10) selon l'une quelconque des revendications 1 à 4, dans lequel le premier axe (L1) est une direction perpendiculaire au substrat du substrat (24).

6. Dispositif de génération d'impulsion (10) selon l'une quelconque des revendications 1 à 5, dans lequel la portion de génération (30) détecte une fuite de champ magnétique lorsque le moment magnétique (M) du rotor de spin (18) est en regard de la direction selon le second axe (L2).

7. Dispositif de génération d'impulsion (10) selon l'une quelconque des revendications 1 à 5, dans lequel
la portion de génération (30) comporte
une couche intermédiaire (32) prévue en contact avec le rotor de spin (18), et constituée d'un métal non ferromagnétique ou d'un isolant,
une couche fixe (34) prévue en contact avec la couche intermédiaire (32), et ayant un moment magnétique (M) fixe dans la direction selon le second axe (L2), et
une portion d'acquisition (36) configurée pour acquérir un courant circulant entre le rotor de spin (18) et la couche fixe (34) ou une tension générée entre le rotor de spin (18) et la couche fixe (34).
